Europäisches Patentamt

European Patent Office

Office européen des brevets

(19)

(11) **EP 1 044 502 B1**

(12) **EUROPÄISCHE PATENTSCHRIFT**

(45) Veröffentlichungstag und Bekanntmachung des Hinweises auf die Patenterteilung:
**20.03.2002 Patentblatt 2002/12**

(21) Anmeldenummer: **98966801.7**

(22) Anmeldetag: **22.12.1998**

(51) Int Cl.⁷: **H03K 17/16**, H03K 17/082

(86) Internationale Anmeldenummer:
**PCT/DE98/03768**

(87) Internationale Veröffentlichungsnummer:
**WO 99/35743 (15.07.1999 Gazette 1999/28)**

(54) **VERFAHREN UND VORRICHTUNG ZUR KURZSCHLUSS- UND ÜBERLASTAUSSCHALTUNG MIT EINEM HALBLEITERBAUELEMENT**

METHOD AND DEVICE FOR SHORT-CIRCUIT AND OVERLOAD CIRCUIT BREAKING USING A SEMICONDUCTOR COMPONENT

PROCEDE ET DISPOSITIF DE COUPURE EN CAS DE COURT-CIRCUIT ET DE SURCHARGE AU MOYEN D'UN COMPOSANT A SEMICONDUCTEUR

(84) Benannte Vertragsstaaten:
**DE FR IT**

(30) Priorität: **30.12.1997 DE 19758233**

(43) Veröffentlichungstag der Anmeldung:
**18.10.2000 Patentblatt 2000/42**

(73) Patentinhaber: **SIEMENS AKTIENGESELLSCHAFT**
**80333 München (DE)**

(72) Erfinder:
• **WEINERT, Ulrich**
**D-91074 Herzogenaurach (DE)**
• **GRIEPENTROG, Gerd**
**D-91058 Erlangen (DE)**

(56) Entgegenhaltungen:
**WO-A-88/08228        US-A- 5 390 070**

**Beschreibung**

Die Erfindung bezieht sich auf ein Verfahren zur Kurzschluß- und Überlastabschaltung mit einem Halbleiterbauelement, insbesondere zur Abschaltung mit als JFET ausgebildeten aktiven Limitern auf Siliziumcrbid(SiC)-Basis, wobei beim Bauelement mit Drain, Source und Gate eine vorgegebene Gate-Source-Spannung anliegt sowie ein vorgegebener Strom fließt und sich über dem Bauelement eine Spannung als resultierender Spannungsabfall ergibt. Daneben bezieht sich die Erfindung auch auf die zugehörige Vorrichtung zur Durchführung des Verfahrens.

Sowohl der eigentliche Kurzschluß als auch der ÜberlastBetriebsfall werden nachfolgend mit dem Begriff "Kurzschluß" bezeichnet. In solchen Betriebsfällen soll der Strom im elektrische Netz möglichst schnell ausgeschaltet werden.

Während eines Kurzschlusses sind unvermeidliche thermische und elektrodynamische Beanspruchungen von für die Ausschaltung eingesetzten elektrischen oder elektronischen Bauelementen an die Erkennungzeit des Kurzschlusses und an die zur Ausschaltung notwendigen Zeit gekoppelt. Gegenwärtig sind Halbleiterbauelemente speziell auf SiC-Basis in der Entwicklung, deren Eigenschaften - wie geringe Durchgangsverluste, Überlastbarkeit, hohe Sperrspannung - zukünftig auch in der Praxis eine strombegrenzende und nahezu verzögerungsfreie Kurzschlußausschaltung erlauben werden. Damit ist eine drastische Reduzierung von Durchlaßstrom und Stromwärmeintegral verbunden. Wenn es gelingt, durch vergleichende Simulationsrechnungen für die SiC-basierten Halbleiter-Bauelemente geeignete Beschreibungsgleichungen aufzufinden werden, können darauf aufbauend Verfahren abgeleitet werden, die eine gleichermaßen für die Halbleiterbauelemente und das Netz gefahrlose Kurzschlußausschaltung gewährleisten.

Aus der EP 0 717 887 B1 ist ein Wechselstromsteller bekannt, der Verwendung von zwei antiseriell geschalteten Halbleiterbauelementen auf Siliziumcarbid (SiC-Basis) macht. Weiterhin wird in der DE 195 48 443 A1 eine Halbleiteranordnung zur Strombegrenzung in SiC-Technologie beschrieben. Dabei geht es im wesentlichen um den Aufbau des Bauelementes mit den einzelnen Halbleitergebieten. Weiterhin ist aus der US 4 228 367 A ein Hochgeschwindigkeitsschaltkreis für Analogsignale mit Halbleiterbauelementen bekannt, bei dem als Bauelemente sog. $J_{FETS}$ verwendet werden, wobei dem Schaltkreis Mittel zur Fehlerüberwachung zugeordnet sind, bei denen die strombegrenzende Wirkung der als Limiter wirkenden $J_{FETS}$ zum Einsatz kommt. Es handelt sich hierbei um klassische Feldeffekttransistoren auf Silizium (Si)-Basis.

Davon ausgehend ist es Aufgabe der Erfindung, ein Verfahren und die zugehörige Vorrichtung anzugeben, welche mit Halbleiterbauelementen auf der Basis der SiC-Technologie ein möglichst schnelles Unterbrechen von stromführenden Leitungen ermöglichen.

Die Aufgabe ist erfindungsgemäß bei einem Verfahren der eingangs genannten Art dadurch gelöst, daß die Gate-Source-Spannung am $J_{FET}$ in Abhängigkeit vom Strom so geführt wird, daß die Spannung nach Ausräumung von Ladungsträgern einen möglichst großen Wert annimmt, der aber für JFET und Stromkreis noch unkritisch ist, wobei für die Führung Gate-Source-Spannung folgender Algorithmus verwendet wird:

$$U_{GS} = U_{on}\left[1 - \sqrt{\frac{I_{JFET}(t)}{G_{JFET}(U_{JFET})}}\right] \qquad (5)$$

wobei $U_{on}$ die Schaltspannung, $I_{JFET}$ der zeitabhängige Strom und $G_{JFET}$ eine nur von $U_{JFET}$ abhängige Funktion bedeuten.

Bei der zugehörigen Vorrichtung kann ein Prozessor zur Verarbeitung von anfallenden Meßdaten zur Kurzschlußfrüherkennung unter Verwendung von Gleichung.(5) eingesetzt werden. Dabei führt der Prozessor neben der Steuerfunktion für das Bauelement auch eine Regelfunktion aus und zwar als PI-Regelung. Der Prozessor umfaßt eine Reglereinheit und eine Einheit zur Ansteuerung des Bauelementes mit vorgebbarem Regelalgorithmus. Letzterer Algorithmus kann aus den Beschreibungsgleichungen des JFET abgeleitet werden.

Weitere Einzelheiten und Vorteile der Erfindung ergeben sich aus der nachfolgenden Beschreibung von Ausführungsbeispielen anhand der Zeichnung in Verbindung mit weiteren Unteransprüchen. Es zeigen

| | |
|---|---|
| Figur 1 | das Kennlinienfeld eines gesteuerten JFET, |
| Figur 2 und Figur 3 | den Verlauf des normierten Kurzschlußstromes $I_{JFET}$ und der Gate-Source-Spannung $U_{GS}$ einerseits sowie der Netzspannung $V_{Netz}$ und der JFET-Spannung $U_{JFET}$ andererseits bei Führung von $U_{GS}$ nach konventioneller Vorgehensweise, |
| Figur 4 | eine Anordnung mit Signalflußplan für eine JFET-Regelung bei Kurzschlußausschaltung, und |
| Figur 5 | und Figur 6 den Verlauf von Kurzschlußstrom $U_{JFET}$ und Gate-Source-Spannung $U_{GS}$ einerseits sowie der JFET-Spannung und der Netzspannung $U_{Netz}$ andererseits entsprechend den Figu- |

ren 2 und 3 bei Anwendung der erfindungsgemäßen Vorgehensweise.

Die Figuren werden teilweise gemeinsam beschrieben. Gleiche Einheiten haben in den Figuren gleiche bzw. sich entsprechende Bezugszeichen.

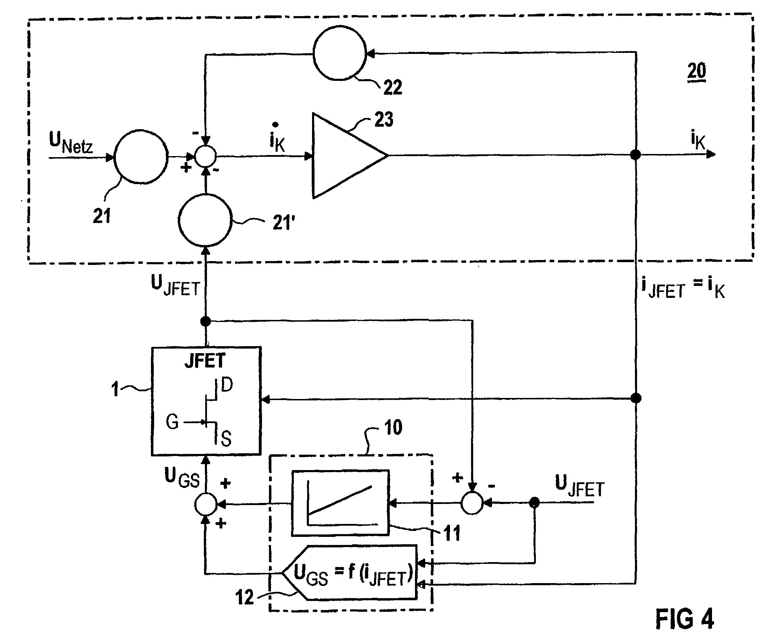

In Zusammenhang zur Ermittlung von Algorithmen zur Kurzschlußfrüherkennung werden elektrische Halbleiterbauelemente als aktive Limiter betrachtet, da die strombegrenzende Wirkung schon bei Stromstärken weit unter der Sättigungsschwelle $I_{sat}$ einsetzen soll. Solche Halbleiterbauelemente bilden sog. JFET's ("junction field effect transistor") bzw. Sperrschicht-Feldeffekt-Transistoren. Der Betrieb derartiger JFET's wird durch den JFET-Strom $J_{FET}$ bei einer dem Bauelement aufgeprägten Gate-Source-Spannung $U_{GS}$ beschrieben, woraus sich ein zugehöriger Spannungsabfall $U_{JFET}$ ergibt. Die so definierten JFET's sollen als aktive Limiter zur Unterbrechung von stromführenden Leitungen bzw. Kurzschlußausschaltung von Netzen einsetzbar sein. Eine zugehöriger Stromlaufplan eines Kurzschlußstromkreises 20 und einem JFET 1 wird anhand Figur 4 beschrieben.

Nach Erkennung des Kurzschlusses wird der JFET 1 durch Variation der Gate-Source-Spannung $U_{GS}$ gesteuert. Der zunächst ungesteuerte JFET 1 mit $U_{GS} = 0$ V besitzt im isothermen Betriebsfall die Kennlinie:

$$I_d = I_{sat} \cdot \left( \frac{U_{JFET}^{\beta}}{U_{sat}^{\beta} + U_{JFET}^{\beta}} \right)^{\frac{1}{\beta}} \tag{1}$$

mit

$I_d$ = Durchlaßstrom
$I_{sat}$ = Sättigungsstrom
$U_{sat}$ = Sättigungsspannung (= $R_{ON} * I_{sat}$)
$R_{ON}$ = Widerstand des JFET im Arbeitspunkt
$U_{JFET}$ = Spannung über dem JFET (= $U_{DS}$)
$\beta$ = Sättigungsexponent

Hierbei liegt der Sättigungsstrom $I_{sat}$ etwa im Bereich des 10 bis 16-fachen Nennstromes. Bei höheren Spannungen ($U > U_{ion}$) treten zusätzliche bipolare Effekte auf, die durch folgenden Ionisierungsterm beschrieben werden können:

$$I_{ion} = I_{sat1} \cdot \sqrt{\frac{U_{JFET} - U_{ion}}{x_m \cdot U_{th}}} \cdot \exp\left( \sqrt{\frac{U_{JFET} - U_{ion}}{x_m \cdot U_{th}}} \right) \quad \text{für} \quad U_{JFET} > U_{ion} \tag{2}$$

$$(sonst = 0)$$

mit

$I_{ion}$ = Ionisierungsstrom
$I_{sat1}$ = Ionisations-Sättigungsstrom
$U_{th}$ = Thermospannung (= $k_B * T / q_e$)
$U_{ion}$ = Ionisierungsspannung
$x_m$ = Emissionskoeffizient

Der Einfluß der Gate-Source-Spannung am JFET kann durch einen Faktor berücksichtigt werden, so daß die vollständige Kennlinie des isothermen JFET's lautet:

$$i_{JFET} = \left( 1 - \frac{U_{GS}}{U_{on}} \right)^2 \cdot (I_d + I_{ion}) \tag{3}$$

mit
$U_{on}$ = Schwellspannung

Mit $U_{GS}$ = 0 befindet sich das Bauelement im eingeschalteten Zustand mit Durchgangswiderstand $R_{on}$, während mit $U_{GS}$ = $U_{on}$ der Sperrzustand mit $I_{JFET}$ = 0 hergestellt wird.

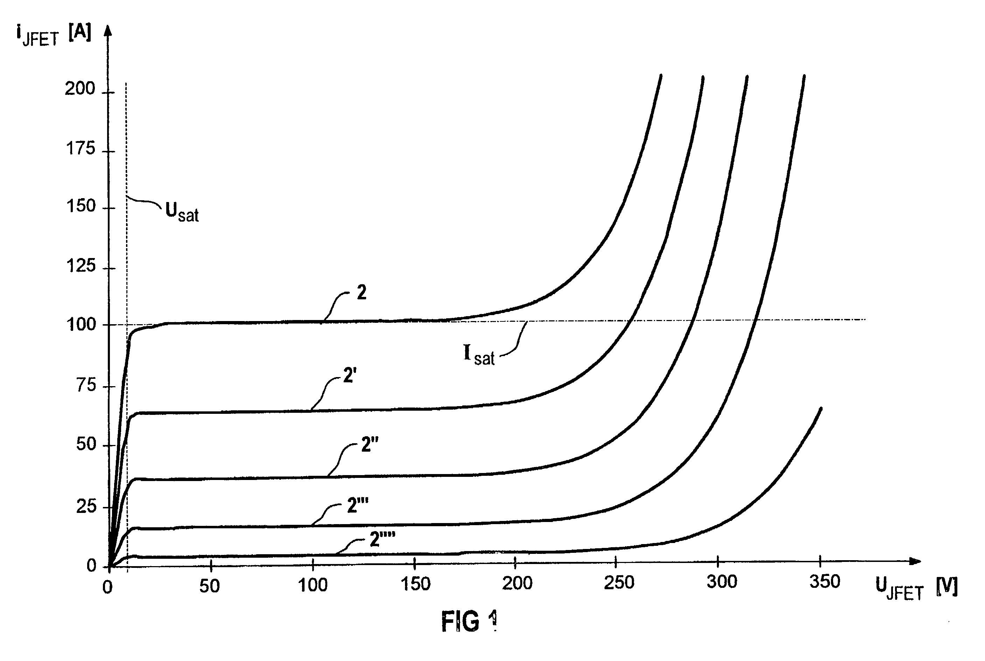

In Figur 1 ist das aus den Gl'en. (1) bis (3) resultierende Kennlinienfeld für ein IFET 1, in der $I_{JFET}$ als Funktion von $U_{JFET}$ aufgetragen ist, dargestellt. Als Parameter wurden $U_{on}$=10V, $U_{sat}$=5V, $I_{sat}$=100A($R_{on}$=50mOhm), Beta=2,5, $U_{ion}$=50V, $I_{sat1}$=10$^{-6}$A, $x_m$=35 gewählt, wobei die Gate-Source-spannung $U_{GS}$ von 0V in Schritten von jeweils -2 V verändert und jeweils der zugehörige Strom $I_{JFET}$ als Funktion der Spannung $U_{JFET}$ erfaßt wurden und als Kennlinien 2, 2`, 2``, ... aufgetragen sind. Die Kennlinien 2, 2`, 2``, ... zeigen jeweils in Abhängigkeit von $U_{GS}$ ein Plateau. Oberhalb einer Spannung von ca. 300 V setzt eine Diodenaktivierung ein, die aber während des JFET-Betriebes vermieden werden kann. Dieser Effekt ist daher in den Gln. (1) bis (3) nicht berücksichtigt.

Für eine dynamische Betrachtung des JFET sind zusätzlich interne Kapazitäten und Widerstände sowie ein Driftglied zu berücksichtigen, worauf im vorliegenden Zusammenhang verzichtet wird.

Um nach der Kurzschlußerkennung eine Ausschaltung herbeizuführen, kann $U_{GS}$ nicht schlagartig von 0 V auf $U_{on}$ gelegt werden, da in diesem Fall der JFET 1 versuchen würde, den - naturgemäß mit Induktivitäten behafteten - Stromkreis sofort zu unterbrechen. In diesem Fall würde die hierbei auftretenden Induktionsspannungen zwangsläufig zur Zerstörung des JFET 1 und/oder von Komponenten des zu schützenden-Stromkreises 20 führen. Des weiteren muß dem JFET 1 nach Aktivierung eine gewisse Zeit - und zwar in der Größenordnung von einigen Mikrosekunden - zur Ausräumung von Ladungsträgern ermöglicht werden.

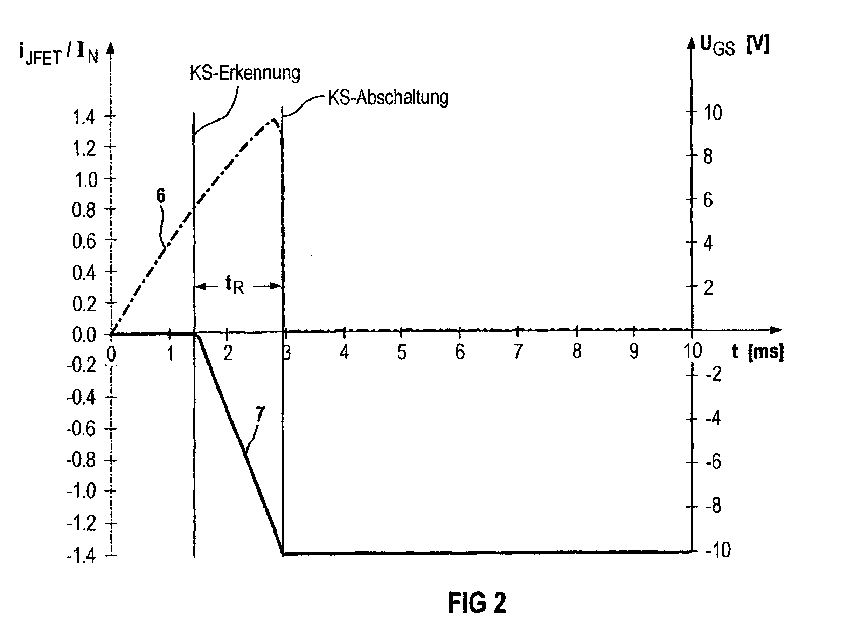

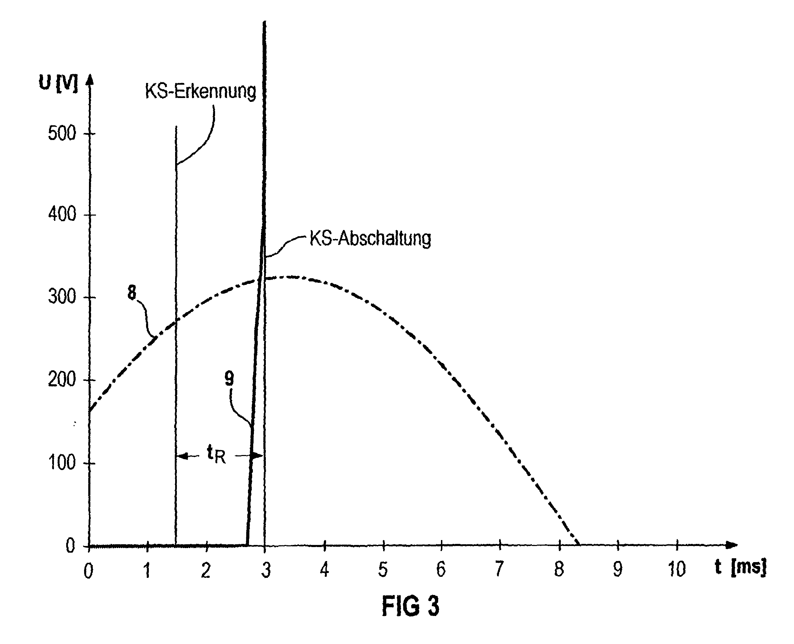

Aus den vorstehend genannten Gründen wird entsprechend dem Stand der Technik die Gate-Source-Spannung $U_{GS}$ auf einer Rampenfunktion von 0 V auf $U_{on}$ heruntergeführt. Hierbei liegt die Annahme zugrunde, daß nach Kurzschlußeintritt der JFET zunächst in seine passive Begrenzung mit $I_{JFET}$ = $I_{sat}$ geht und erst anschließend durch Beeinflussung von $U_{GS}$ ausgeschaltet wird. Erfolgt der Ausschaltvorgang hingegen schon bei weitaus geringeren Strömen im Nennstrombereich, wie es Ziel einer Kurzschlußfrüherkennung ist, ergeben sich die in den Figuren 2 und 3 gezeigten Verhältnisse. Dabei sind die Zeitfunktionen für $I_{JFET}$ mit 6, für $U_{GS}$ mit 7, für $U_{Netz}$ mit 8 und für $U_{JFET}$ mit 9 bezeichnet.

Bei den in den Figuren 1 bis 3 zugrunde liegenden Voraussetzungen reagiert der JFET 1 im Bereich von $U_{GS}$ = 0 bis 7 V fast überhaupt nicht und der Kurzschluß besteht quasi unbeeinflußt weiter. Hieraus würde eine für die nachgeschaltete Anlage ungünstige Verzögerung der Kurzschlußausschaltung resultieren.

Wenn die Gate-Source-Spannung $U_{GS}$ an den Wert

$$U_{on} \cdot \left(1 - \sqrt{I_{JFET}(t)/I_{sat}}\right)$$

erreicht, erhöht sich schlagartig die Spannung über dem JFET 1, um zusätzliche Ionisierungsströme aufzubringen. Bei weiterer Annäherung an $U_{on}$, wird der JFET 1 schließlich zwangsweise ausgeschaltet, obwohl der Kurzschlußstrom bis zu diesem Zeitpunkt kaum vermindert wurde. Hieraus würden hohe Induktionsspannungen resultieren, die für das JFET 1 und den Kurzschlußstromkreis mit hoher Wahrscheinlichkeit unzumutbar sind und ebenfalls zu Zerstörungen führen.

Um die geschilderten Nachteile zu vermeiden, wird nunmehr $U_{GS}$ abhängig vom JFET-Strom so geführt, daß die Spannung $U_{JFET}$

- einerseits unverzüglich nach Ausräumung von Ladungsträgern einen möglichst hohen Wert annimmt,
- der aber andererseits für JFET und Stromkreis unkritisch ist.

Dabei liegt die Spannung üblicherweise unter der Schwelle für eine ggfs. mögliche Diodenaktivierung. Mit diesen Zielfunktionen und den Gln. (1) bis (3) ergibt sich folgender Regelalgorithmus:

$$U_{GS} = U_{on}\left[1 - \sqrt{\frac{I_{JFET}(t)}{\sqrt{I_{SAT}\left(\frac{U_{JFET}^{\beta}}{U_{SAT}^{\beta} + U_{JFET}^{\beta}}\right)^{\frac{1}{\beta}} + I_{sat1} \cdot \sqrt{\frac{U_{JFET} - U_{ion}}{x_m \cdot U_{th}} \cdot \exp\left(\sqrt{\frac{U_{JFET} - U_{ion}}{x_m \cdot U_{th}}}\right)}}}}\right] \qquad (4)$$

Durch Zusammenfassung der bauelementespezifischen Parameter und dem angestrebten Spannungsabfall $U_{JFET}$ während der Kurzschlußausschaltung in einer nur von $U_{JFET}$ abhängigen Funktion $G_{JFET}$ erhält man schließlich die vereinfachte Vorschrift:

$$U_{GS} = U_{on}\left[1 - \sqrt{\frac{I_{JFET}(t)}{G_{JFET}(U_{JFET})}}\right] \qquad (5)$$

Nach Gl. (5) muß also lediglich der durch den JFET 1 fließende Kurzschlußstrom $I_{JFET}$ zur Regelung des JFET 1 bekannt sein. Um Fehlanpassungen infolge Alterungs- und insbesondere Temperaturdrift der Bauelementeparameter zu vermeiden, wird u.U. zusätzlich die Spannung $U_{JFET}$ in einem unterlagerten Regelkreis ausgewertet. Ein zur Regelung notwendiger Prozessor kann also gleichzeitig für die Realisierung der erwünschten Kurzschlußfrüherkennung und - ausschaltung eingesetzt werden.

In Figur 4 ist der resultierende Signalflußplan wiedergegeben. Es ist ein Prozessor 10 für den JFET 1 vorhanden mit einer ersten Reglereinheit 11 mit vorzugsweise PI-Charakteristik und mit einer zweiten Einheit 12 zur Generierung einer Führungsgröße mit dem in GL. (5) angegebenen Regelalgorithmus. Im zugeordneten Kurzschlußstromkreis 20 wird die Induktivität L durch Verstärker 21, 21` mit der Verstärkung 1/L sowie der ohmsche Widerstand R durch einen Verstärker 22 mit der Verstärkung R und durch einen Integrator 23 mit einen die Induktivitäten berücksichtigende Integration des Stromes verkörpert.

Um die geforderte Ladungsträgerausräumung zu gewährleisten, wird $U_{GS}$ innerhalb von einigen µs auf einen Wert geführt, der unmittelbar nach Kurzschlußerkennung die entsprechende JFET-Spannung generiert. Nach aktuellen Erkenntnissen sind dabei, d.h. während der Kurzschlußausschaltung, JFET-Spannungen im Bereich von 250 bis 350 V realistisch.

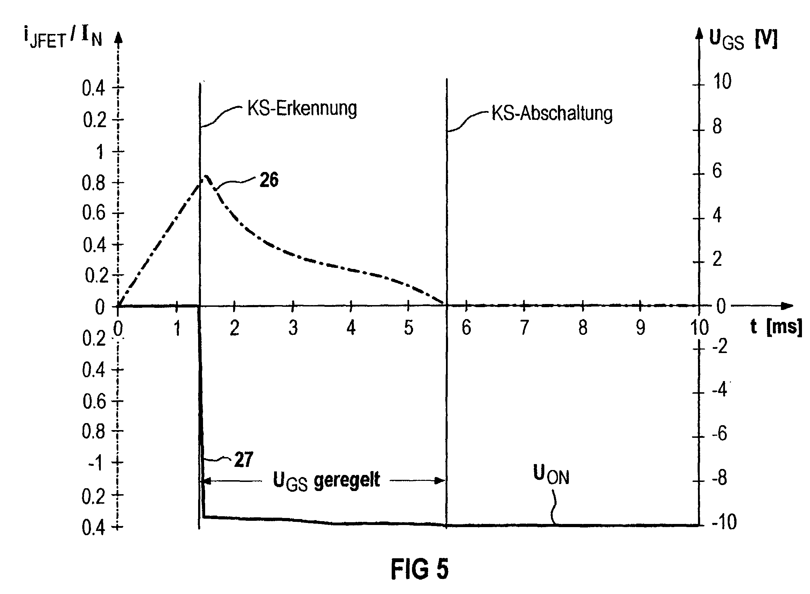

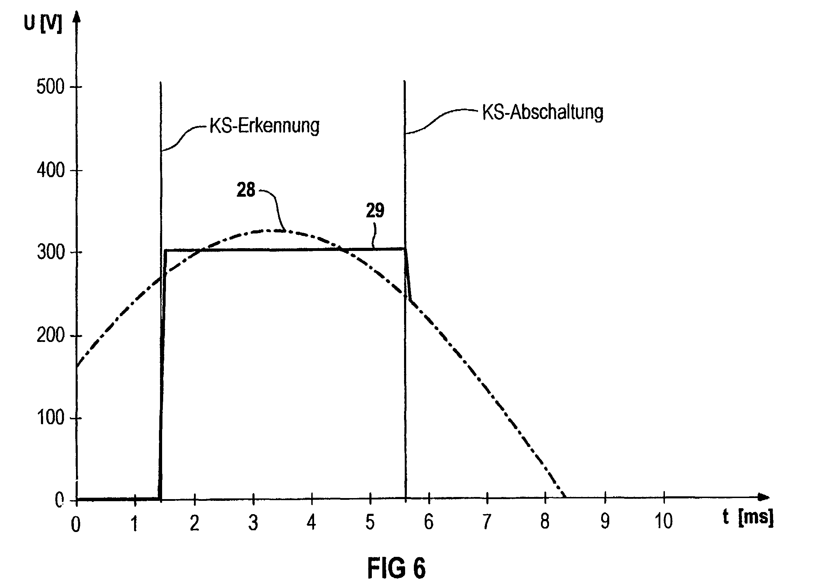

Ein zu Fig. 2/3 vergleichbarer Schaltvorgang mit der neuen $U_{GS}$-Regelung ist in Fig. 5/6 dargestellt. Hier sind entsprechende Zeitfunktionen wie in Figur 2/3 für $I_{JFET}$ 26, für $U_{GS}$ mit 27, für $U_{Netz}$ mit 28 und für $U_{JFET}$ mit 29 bezeichnet. Erkennbar ist, daß die Spannung $U_{GS}$ sofort nach der Kurzschlußerkennung auf einer Rampe in Mikrosekundenbereich zur Ladungsträger-Ausräumung geführt wird. Anschließend erfolgt der geregelte Bereich für $U_{GS}$ bis zur Kurzschluß-Abschaltung.

Aus den Figuren 5 und 6 ergibt sich ein Verlauf des Kurzschlußstromes und der Spannung $U_{GS}$ derart, daß bei

- einem prospektiven Kurzschlußstrom, der dem 1,2-fachen des Nennstromes entspricht ($\eta_\kappa$ = 1,2),
- einem Leistungsfaktor der Kurzschlußmasche von 0,9 (cos$\varphi$ = 0,9) und
- einem Kurzschlußeintrittswinkel, bezogen auf die Netzspannung, von 30° ($\psi$ = 30°)

ein Spannungsabfall $U_{JFET}$ von ca 300 V über dem JFET 1 erzeugt wird. Zusätzliche Spannungsspitzen treten dabei nicht auf.

Insgesamt werden durch das vorstehend beschriebene Verfahren mit der zugehörigen Vorrichtung wesentliche Vorteile erzielt: Im Fehlerfall erfolgt ein unverzüglicher Beginn der Kurzschlußstromausschaltung und damit eine Reduzierung der thermischen und dynamischen Belastung des Schaltkreises und der gesamten Anlage. Im Rahmen eines Eigenschutzes ist bei der Vorrichtung keine Zerstörung des JFET möglich. Da hohe Stromimpulse am Gate des JFET vermieden werden, wird die gesamte Anlage wird vor Überspannungen bewahrt, so daß der geforderte Fremdschutz sichergestellt ist.

## Patentansprüche

1. Verfahren zur Kurzschluß- und Überlastausschaltung mit einem Halbleiterbauelement, insbesondere zur Abschaltung mit als JFET ausgebildeten aktiven Limitern auf Siliziumcarbid - Basis, wobei beim Bauelement (1) mit Drain, Source und Gate eine vorgegebene Gate-Source-Spannung $U_{GS}$ anliegt sowie ein vorgegebener Strom $I_{JFET}$ fließt und sich über dem Bauelement (1) eine Spannung $U_{JFET}$ als resultierender Spannungsabfall ergibt, mit folgenden Verfahrensschritten:

   - im Betriebsfall wird die Gate-Source-Spannung $U_{GS}$ am Bauelement (1) in Abhängigkeit vom Strom $I_{JFET}$ so geführt, daß die Spannung $U_{JFET}$ nach Ausräumung von Ladungsträgern im Bauelement (1) einen möglichst großen Wert annimmt, der für das Bauelement (1) und den abzuschaltenden Stromkreis (20) noch unkritisch ist,

- für die Führung der Gate-Source-Spannung $U_{GS}$ wird folgender Algorithmus verwendet :

$$U_{GS} = U_{on}\left[1 - \sqrt{\frac{I_{JFET}(t)}{G_{JFET}(U_{JFET})}}\right] \qquad (5)$$

wobei $U_{on}$ die Schaltspannung $I_{JFET}$ der zeitabhängige Strom und $G_{JFET}$ eine nur von $U_{JFET}$ abhängige Funktion bedeuten.

2. Verfahren nach Anspruch 1, **dadurch gekennzeichnet, daß** der Strom $_{IJFET}$ zur Steuerung und/ oder Regelung des Bauelementes (1) verwen wird.

3. Verfahren nach einem der vorhergehenden Ansprüche, **dadurch gekennzeichnet, daß** die Spannung $U_{JFET}$ als Istwert am Bauelement (1) erfaßt und mittels eines Regelsignals dazu verwendet wird, um die Parameterdrift des Bauelementes (1) zu kompensieren.

4. Verfahren nach Anspruch 3, **dadurch gekennzeichnet, daß** Steuersignale und Regelsignale einander überlagert werden.

5. Vorrichtung zur Durchführung des Verfahrens nach Anspruch 1 oder einem der Ansprüche 2 bis 4, mit einem Prozessor (10) zur Verarbeitung von anfallenden Meßwerten, **dadurch gekennzeichnet, daß** der Prozessor (10) zur Früherkennung des Kurzschlusses bzw. der Überlast ausgebildet ist und ein Halbleiterbauelement (1) als aktiven Limiter (JFET) zur Überwachung eines Kurzschluß- und Überlaststromkreises (20) ansteuert bzw. ausregelt, wobei die Steuer- und/oder Regelfunktion entsprechend der in Anspruch 1 genannten Gleichung gewählt ist.

6. Vorrichtung nach Anspruch 5, **dadurch gekennzeichnet, daß** der Prozessor (10) eine PI-Regelung ausführt.

7. Vorrichtung nach Anspruch 5 oder Anspruch6, **dadurch gekennzeichnet, daß** der Prozessor (10) eine Reglereinheit (11) und eine weitere Einheit (12) zur Erzeugung einer Führungsgröße mit dem in Anspruch 1 genannten Regelalgorithmus umfaßt, wobei das Summationssignal der Reglereinheit (11) und der weiteren Einheit (12) zur Ansteuerung des Bauelementes (1) als aktiver Limiter (JFET) dient.

**Claims**

1. Method for short-circuit and overload switch-off with a semiconductor component, in particular for shutdown with active limiters taking the form of JFETs on a silicon carbide base, where in the case of the component (1) with drain, source and gate a predefined gate-source voltage $U_{GS}$ is applied and a predefined current $I_{JFET}$ flows, and a voltage $U_{JFET}$ arises across the component (1) as a resulting voltage drop, with the following procedural steps:

- in the operating situation, the gate-source voltage $U_{GS}$ at the component (1) is conducted depending on the current $I_{JFET}$ such that after the removal of charge carriers in component (1) the voltage $U_{JFET}$ assumes as high a value as possible while still remaining non-critical for the component (1) and for the electric circuit (20) to be shut down,
- the following algorithm is used for conduction of the gate-source voltage $U_{GS}$:

$$U_{GS} = U_{on}\left[1 - \sqrt{\frac{I_{JFET}(t)}{G_{JFET}(U_{JFET})}}\right] \qquad (5)$$

where $U_{on}$ is the switching voltage, $I_{JFET}$ is the time-dependent current, and $G_{JFET}$ is a function dependent only on $U_{JFET}$.

**2.** Method in accordance with Claim 1, **characterised in that** the current $I_{JFET}$ is used for control and/or regulation of the component (1).

**3.** Method in accordance with one of the preceding Claims, **characterised in that** the voltage $U_{JFET}$ is sensed as an actual value at the component (1) and is used by means of a regulation signal in order to compensate for the parameter drift of the component (1).

**4.** Method in accordance with Claim 3, **characterised in that** control signals and regulation signals are superimposed on one another.

**5.** Device for implementation of the method in accordance with Claim 1 or one of Claims 2 to 4, with a processor (10) for processing measured values which are obtained, **characterised in that** the processor (10) is designed for early detection of the short-circuit or of the overload, and controls or adjusts a semiconductor component (1) as an active limiter (JFET) for monitoring a short-circuit and overload current circuit (20), where the control and/or regulation function is chosen in accordance with the equation given in Claim 1.

**6.** Device in accordance with Claim 5, **characterised in that** the processor (10) carries out a PI control function.

**7.** Device in accordance with Claim 5 or 6, **characterised in that** the processor (10) comprises a regulator unit (11) and a further unit (12) for the generation of a reference variable with the regulation algorithm given in Claim 1, where the summation signal from the regulator unit (11) and the further unit (12) is used for controlling the component (1) as an active limiter (JFET).

**Revendications**

**1.** Procédé pour la coupure en cas de court-circuit et de surcharge avec un composant à semi-conducteur, notamment pour la coupure avec des limiteurs actifs conçus comme des JFET sur une base de carbure de silicium, dans lequel, dans le cas d'un composant (1) avec drain, source et grille, une tension grille-source $U_{GS}$ prédéterminée est appliquée et un courant $I_{JFET}$ prédéterminé passe et une tension $U_{JFET}$ est obtenue comme chute de tension résultante sur le composant (1), avec les étapes de procédé suivantes :

- dans le cas du fonctionnement, on commande la tension grille-source $U_{GS}$ au composant (1) en fonction du courant $I_{JFET}$ de telle sorte que la tension $U_{JFET}$ après élimination des porteurs de charge dans le composant (1) prend une valeur maximale qui n'est pas encore critique pour le composant (1) et pour le circuit de courant (20) à couper,
- pour la commande de la tension grille-source $U_{GS}$, on utilise l'algorithme suivant :

$$U_{GS} = U_{on}\left[1 - \sqrt{\frac{I_{JFET}(t)}{G_{JFET}(U_{JFET})}}\right] \tag{5}$$

$U_{on}$ étant la tension d'enclenchement, $I_{JFET}$ le courant dépendant du temps et $G_{JFET}$ une fonction dépendant seulement de $U_{JFET}$.

**2.** Procédé selon la revendication 1, **caractérisé par le fait qu'**on utilise le courant $I_{JFET}$ pour la commande et/ou la régulation du composant (1).

**3.** Procédé selon l'une des revendications précédentes, **caractérisé par le fait qu'**on détecte la tension $U_{JFET}$ comme valeur réelle au composant (1) et on l'utilise au moyen d'un signal de régulation pour compenser la dérive de paramètres du composant (1).

**4.** Procédé selon la revendication 3, **caractérisé par le fait qu'**on superpose les uns aux autres des signaux de commande et des signaux de régulation.

**5.** Dispositif pour la mise en oeuvre du procédé selon la revendication 1 ou selon l'une des revendications 2 à 4, comportant un processeur (10) pour le traitement de valeurs de mesure arrivant, **caractérisé par le fait que** le processeur (10) est conçu pour la détection précoce du court-circuit ou de la surcharge et commande ou régule un composant à semi-conducteur (1) comme limiteur actif (JFET) pour la surveillance d'un circuit de courant de court-circuit et de surcharge (20), la fonction de commande et/ou de régulation étant choisie conformément à l'équation donnée dans la revendication 1.

6.  Dispositif selon la revendication 5, **caractérisé par le fait que** le processeur (10) met en oeuvre une régulation PI.

7.  Dispositif selon la revendication 5 ou 6, **caractérisé par le fait que** le processeur (10) comprend une unité de régulateur (11) et une autre unité (12) pour la production d'une grandeur de commande avec l'algorithme de régulation donné dans la revendication 1, le signal cumulé de l'unité de régulateur (11) et de l'autre unité (12) servant à la commande du composant (1) comme limiteur actif (JFET).

FIG 1

FIG 2

FIG 3

FIG 4

FIG 5

EP 1 044 502 B1

FIG 6

EP 1 044 502 B1